# EUROPÄISCHE PATENTSCHRIFT

(11) **EP 1 595 294 B1**
(45) Veröffentlichungstag und Bekanntmachung des Hinweises auf die Patenterteilung: **04.10.2006**
(21) Anmeldenummer: 04766478.4
(22) Anmeldetag: 11.08.2004
(51) Int. Cl.: H01L 41/22, H01L 41/24

(54) **VERFAHREN ZUM HERSTELLEN EINER ELEKTRISCHEN KONTAKTIERUNG EINES PIEZOELEKTRISCHEN AKTORS UND POLARISIERUNG DES PIEZOELEKTRISCHEN AKTORS**
METHOD FOR CREATING AN ELECTRICAL CONTACT FOR A PIEZOELECTRIC ACTUATOR AND POLARIZING THE PIEZOELECTRIC ACTUATOR
PROCEDE DE PRODUCTION D'UN CONTACT ELECTRIQUE D'UN ACTIONNEUR PIEZO-ELECTRIQUE ET POLARISATION DE L'ACTIONNEUR PIEZO-ELECTRIQUE

(30) Priorität: 21.08.2003 DE 10338486
(43) Veröffentlichungstag der Anmeldung: 16.11.2005
(73) Patentinhaber: SIEMENS AKTIENGESELLSCHAFT, 80333 München (DE)
(72) Erfinder: DENZLER, Michael, 93055 Regensburg (DE); DÖLLGAST, Bernhard, 91054 Erlangen (DE)
(86) Internationale Anmeldenummer: PCT/EP2004/051775
(87) Internationale Veröffentlichungsnummer: WO 2005/022657

(56) Entgegenhaltungen:
- EP-A- 0 350 941
- DE-A- 10 026 635
- DE-A- 10 231 929
- US-A- 5 325 012

## Beschreibung

Die Erfindung betrifft ein Verfahren zum Herstellen einer elektrischen Kontaktierung eines piezoelektrischen Aktors und ein Verfahren zum Polarisieren des piezoelektrischen Aktors gemäß dem Oberbegriff des Patentanspruchs 1.

Piezoelektrische Aktoren bestehen üblicherweise aus gemeinsam gesinterten Stapeln von piezokeramischen Schichten mit dazwischenliegenden Metallelektroden. Jede zweite Metallelektrode ist an einer ersten Seite herausgeführt und mit einer ersten Metallisierungsbahn verbunden. An der gegenüberliegenden Seite ist eine zweite Metallisierungsbahn vorgesehen, die mit den anderen Metallelektroden elektrisch leitend verbunden ist. Somit sind zwei Metallelektrodenanordnungen vorgesehen, die voneinander elektrisch isoliert sind.

Beim Betrieb der piezoelektrischen Aktoren werden parallel zu einer Polarisationsrichtung der piezokeramischen Schichten große Kräfte, aber nur kleine relative Auslenkungen erreicht. Zur Erzielung geringer Betriebsspannungen besteht der piezoelektrische Aktor aus einer Vielzahl von piezokeramischen Schichten. Zur Polarisierung des Aktors wird an die zwei Elektrodenstrukturen ein elektrisches Polarisationsfeld angelegt, wodurch sich eine maximale remanente Polarisierung und eine geordnete Verteilung der in Feldrichtung in den Kristallen der keramischen Schichten ausgerichteten Domänen gegenüber einem unpolarisierten Ausgangszustand ergibt. Die Polarisierung wird bei einer Temperatur der piezokeramischen Schicht durchgeführt, die über der Curietemperatur der piezokeramischen Schicht liegt.

Weiterhin ist es zur elektrischen Kontaktierung des piezoelektrischen Aktors erforderlich, die Metallisierungsbahnen mit elektrischen Leitungen zu kontaktieren. Dazu werden die elektrischen Leitungen in einem Lötprozess an den Metallisierungsbahnen festgelötet.

Aus der europäischen Patentanmeldung EP 0 350 941 A2 ist ein piezoelektrischer Aktor und ein Verfahren zur Herstellung des piezoelektrischen Aktors bekannt, der in Form von mehreren piezoelektrischen Schichten aufgebaut ist, wobei zwischen den piezoelektrischen Schichten jeweils eine Elektrode angeordnet ist. Jede zweite Elektrode ist mit einer Metallisierungsbahn elektrisch leitend verbunden, die an einer Außenseite des piezoelektrischen Aktors angeordnet ist. Die anderen Elektroden sind mit einer zweiten Metallisierungsbahn elektrisch leitend verbunden, die gegenüberliegend zur ersten Metallisierungsbahn auf der Außenseite des piezoelektrischen Aktors angeordnet ist. Der piezoelektrische Aktor wird für einen Verbindungsvorgang über die Curietemperatur erwärmt, so dass eine chemische Bindung zwischen den Elektroden und den piezokeramischen Schichten ausgebildet wird. In einem folgenden Abkühlungsprozess wird die Polarisierung der piezokeramischen Schichten durchgeführt, wobei die Temperatur der piezokeramischen Schichten noch über der Curietemperatur liegt. In einem späteren Lötprozess werden elektrische Leitungen an die Metallisierungsbahnen gelötet.

Aus der deutschen Patentanmeldung DE 100 26 635 A1 ist ein Verfahren zum Herstellen einer Lötverbindung zwischen einer elektrischen Kontaktfläche eines piezokeramischen Aktors und einer Drahtoberfläche beschrieben. Dabei werden Metallisierungsstreifen des piezoelektrischen Aktors mit parallel angeordneten Drähten verlötet. Die Verlötung erfolgt nach der Polarisierung des piezokeramischen Aktors. Bei dem Lötvorgang weist der piezokeramische Aktor eine Temperatur auf, die unterhalb der Curietemperatur liegt.

Die Aufgabe der Erfindung besteht darin, ein Verfahren zum Herstellen einer elektrischen Kontaktierung eines piezoelektrischen Aktors und ein Verfahren zur Polarisierung des piezoelektrischen Aktors bereit zu stellen, die schneller auszuführen ist.

Die Aufgabe der Erfindung wird durch das Verfahren gemäß Patentanspruch 1 gelöst. Das Verfahren gemäß Patentanspruch 1 weist den Vorteil auf, dass die elektrische Kontaktierung des piezoelektrischen Aktors und die Polarisierung des piezoelektrischen Aktors in kürzerer Zeit durchgeführt werden können. Dieser Vorteil wird dadurch erreicht, dass die elektrische Kontaktierung und die Polarisierung wenigstens teilweise gleichzeitig durchgeführt werden. Vorzugsweise wird der Lötvorgang oberhalb der Curietemperatur durchgeführt und gleichzeitig wird die Polarisierung der piezokeramischen Schichten des Aktors durchgeführt.

Weitere vorteilhafte Ausführungsformen der Erfindung sind in den abhängigen Ansprüchen angegeben.

In einer vorteilhaften Weiterbildung des erfindungsgemäßen Verfahrens wird die Polarisierungsspannung auch während einer Abkühlphase bis unter die Curietemperatur angelegt und auf einen maximalen Wert begrenzt. Damit wird zum Einen erreicht, dass die Polarisierung sicher beibehalten wird und zum Anderen wird eine Beschädigung der piezokeramischen Schichten vermieden.

In einer weiteren Ausführungsform des erfindungsgemäßen Verfahrens wird die Polarisierungsspannung schon vor Erreichen einer maximalen Temperatur angelegt und der fließende Strom wird während des Erwärmens des Aktors auf einen maximalen Wert begrenzt. Damit wird schon vor Erreichen der maximalen Temperatur des piezoelektrischen Aktors eine Polarisierung erreicht und gleichzeitig wird durch die Begrenzung auf einen maximalen Stromwert eine Beschädigung der piezokeramischen Schichten sicher vermieden. In einer weiteren bevorzugten Ausführungsform wird die während der Polarisierung angelegte Spannung erfasst und ausgewertet, um eine Aussage über die Qualität der Polarisierung oder über die Qualität des piezoelektrischen Aktors machen zu können.

In einer weiteren bevorzugten Ausführungsform wird der während der Polarisierung fließende Strom erfasst und ausgewertet, um die Polarisierung und/oder den piezoelektrischen Aktor bewerten zu können.

In einer bevorzugten Ausführungsform werden die Leitungen über Heizblöcke auf Lötflächen der Kontakte gedrückt, wobei die Heizblöcke den Aktor wenigstens teilweise erwärmen. Auf diese Weise wird der Lötprozess durch das mechanische Aufdrücken der Leitungen erleichtert und zudem wird die Temperatur im Bereich der Lötverbindung zugeführt. Damit wird eine Verbesserung des Lötprozesses erreicht.

In einer weiteren vorteilhaften Ausführungsform werden mehrere Aktoren gleichzeitig mit Leitungen verlötet und polarisiert. Damit wird eine effiziente Durchführung des Verfahrens erreicht, so dass eine Massenfertigung möglich ist.

Die Erfindung wird im Folgenden anhand der Figuren näher erläutert. Es zeigen:
Figur 1 einen piezoelektrischen Aktor;
Figur 2 einen Querschnitt durch einen Randbereich des piezoelektrischen Aktors nach dem Lötprozess;
Figur 3 eine schematische Darstellung einer Anordnung zur Durchführung des erfindungsgemäßen Verfahrens; und
Figur 4 ein Diagramm mit den zeitlichen Verläufen verschiedener Parameter während der Durchführung des erfindungsgemäßen Verfahrens.

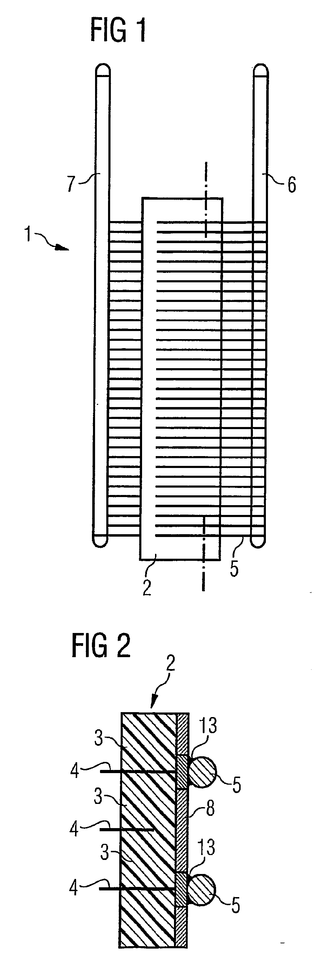

Figur 1 zeigt in einer schematischen Darstellung einen piezokeramischen Aktor 1, der ein piezokeramisches Bauelement 2 mit einer Vielzahl von piezokeramischen Schichten 3 (Figur 2) aufweist. Zwischen zwei Schichten 3 ist jeweils eine flächige Elektrode 4 (Figur 2) ausgebildet. Die Elektroden 4 sind über Drähte 5 mit einem ersten bzw. einem zweiten Kontaktstift 6, 7 elektrisch leitend verbunden. Jede zweite Elektrode 4 ist über einen Draht 5 mit dem ersten Kontaktstift 6 elektrisch leitend verbunden. Die anderen Elektroden 4 sind über Drähte 5 mit dem zweiten Kontaktstift 7 elektrisch leitend verbunden. Auf diese Weise ist eine Schichtstruktur ausgebildet, wobei jede piezokeramische Sicht 3 von zwei Elektroden 4 begrenzt wird, die elektrisch leitend mit verschiedenen Kontaktstiften 6, 7 verbunden sind. Durch das Anlegen von verschiedenen Spannungspotentialen an den ersten und den zweiten Kontaktstift 6, 7 werden alle piezokeramischen Schichten 3 mit der gleichen Spannung beaufschlagt, so dass sich die Schichten 3 entsprechend der angelegten Spannung ausdehnen.

Figur 2 zeigt einen Teilquerschnitt von einem Randbereich des piezokeramischen Bauteils 2. Auf dem piezokeramischen Bauteil 2 ist eine erste Metallisierungsbahn 8 aufgebracht. Die erste Metallisierungsbahn 8 ist elektrisch leitend mit jeder zweiten Elektrode 4 verbunden. Gegenüberliegend zur ersten Metallisierungsbahn 8 ist auf der anderen Seite des Bauteils 2 eine zweite Metallisierungsbahn 9 angeordnet, die mit den anderen Elektroden 4 elektrisch leitend verbunden ist. Die Metallisierungsbahn 8 ist über eine Lotschicht 13 mit den Drähten 5 elektrisch leitend verbunden. Die Drähte 5 der ersten Metallisierungsbahn 8 sind an den ersten Kontaktstift 6 geführt.

In entsprechender Weise ist die zweite Metallisierungsbahn 9 über Drähte 5 elektrisch leitend mit dem zweiten Kontaktstift 7 verbunden.

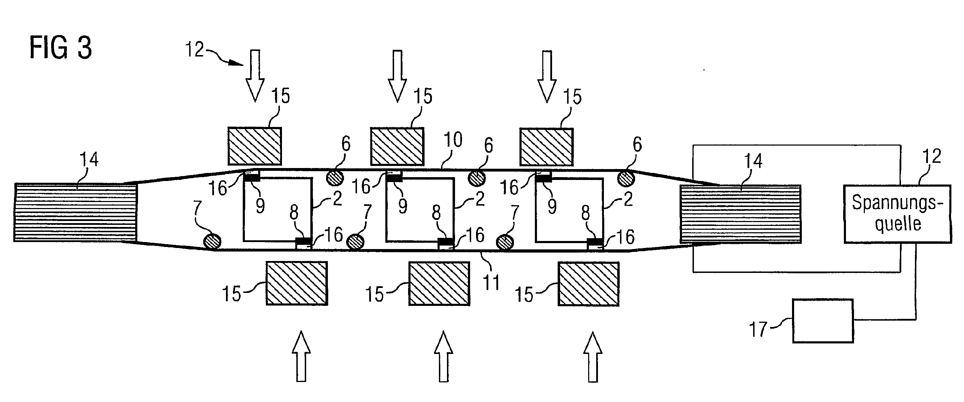

Figur 3 zeigt eine schematische Anordnung zur Durchführung des erfindungsgemäßen Verfahrens.

Bei der Herstellung des piezoelektrischen Aktors 1 werden zuerst die Schichten 3 und die Elektroden 4 in einem Sinterprozess hergestellt. Zudem ist es erforderlich, eine Polarisierung der piezokeramischen Schichten 3 durchzuführen. Dazu wird eine Polarisierungsspannung über die Elektroden 4 an die Schichten 3 angelegt, wobei die piezokeramischen Schichten 3 eine Temperatur aufweisen, die über der Curietemperatur der piezokeramischen Schichten 3 liegt. Weiterhin ist es erforderlich, elektrische Leitungen 10, 11 an die Metallisierungsbahnen 8, 9 anzuschließen.

Bei dem erfindungsgemäßen Verfahren werden in der dargestellten Ausführungsform drei piezoelektrische Bauteile 2 angeordnet. Die Bauteile 2 weisen bereits die piezokeramischen Schichten 3, die Elektroden 4 und die Metallisierungsbahnen 8, 9 auf. Die Metallisierungsbahnen 8, 9 sind an gegenüberliegenden Seiten und an diametral angeordneten Eckbereichen des im Querschnitt quadratförmig ausgebildeten Bauteils 2 angeordnet. An die erste und die zweite Metallisierungsbahn 8, 9 werden erste und zweite Leitungen 10, 11 angelegt. Die ersten und die zweiten Leitungen 10, 11 sind in Form von Drähten ausgebildet und mit einer Spannungsquelle 12 elektrisch leitend verbunden. Die Enden der Leitungen 10, 11 liegen an Abstandsblöcken 14 an.

Die Bauteile 2 werden auf eine Temperatur erhitzt, die oberhalb der Curietemperatur der piezoelektrischen Schichten 3 liegt. Anschließend werden die Leitungen 10, 11 gegen die erste und zweite Metallisierungsbahn 8, 9 gedrückt. Zudem wird Lot 13 zwischen die erste und die zweite Metallisierungsbahn und der ersten bzw. zweiten Leitung 10, 11 eingebracht. Als Lotmaterial wird Lot 13 verwendet, das eine Löttemperatur aufweist, die oberhalb der Curietemperatur liegt. Vorzugsweise werden zum Andrücken der ersten und der zweiten Leitung 10, 11 Heizelemente 15 verwendet, die neben dem Andrücken der ersten und der zweiten Leitungen 10, 11 zugleich auch das Bauteil 2 wenigstens teilweise erhitzen. In einer bevorzugten Ausführungsform ist das Lot 13 in Form einer Lotfolie 16 zwischen den Metallisierungsbahnen 8, 9 und den ersten und den zweiten Leitungen 10, 11 eingelegt.

Gleichzeitig zum Lötvorgang wird eine Polarisierungsspannung über die Spannungsquelle 12 an die Leitungen 10, 11 angelegt und dadurch die Polarisierung der piezoelektrischen Schichten 3 bewirkt. Bei der Polarisierung werden Feldstärken von 1 bis 2 kV/mm verwendet. Die verwendeten Stromwerte liegen bei einigen A/cm². Vorzugsweise wird die Polarisierung schon vor Erreichen einer Maximaltemperatur des Bauteils 2 angelegt. Zudem wird vorzugsweise die Polarisierungsspannung beibehalten, wenn sich das Bauteil 2 von der maximalen Temperatur bis unter die Curietemperatur abkühlt. Damit die Stromstärke beim Erhitzen des Bauteils 2 nicht über einen Maximalstrom steigt, wird die Stromstärke von der Spannungsquelle 12 auf einen Maximalwert begrenzt. Gleichzeitig wird die anliegende Spannung beim Abkühlen des Bauteils 2 von der Spannungsquelle 12 auf eine Maximalwert begrenzt, damit keine Beschädigung der piezokeramischen Schichten 3 erfolgt.

Die Leitungen 10, 11 sind oder werden an die ersten bzw. zweiten Kontaktstifte 6, 7 angelötet. Nach dem Löt- und Polarisierungsvorgang werden die Leitungen 10, 11 aufgetrennt, so dass einzelne Aktoren 1 gemäß Figur 1 erhalten werden.

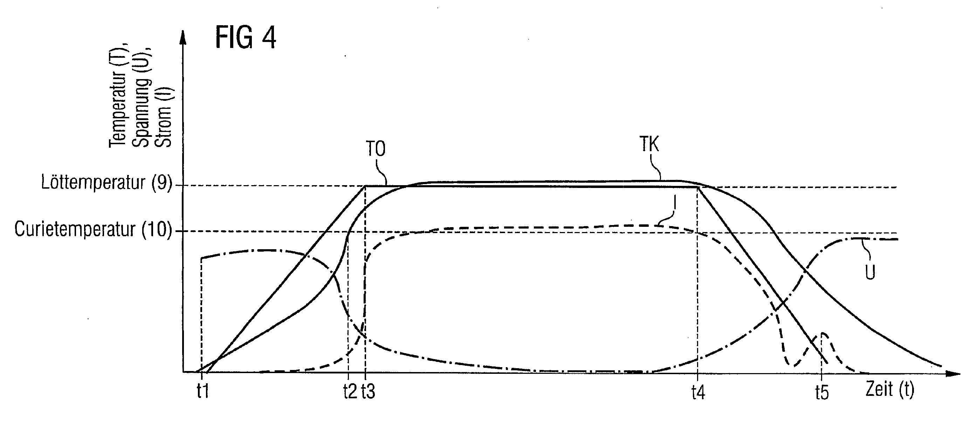

Figur 4 zeigt in einem Diagramm den zeitlichen Verlauf der Polarisierungsspannung U und des Polarisierungsstromes I. Zudem sind in dem Diagramm ist die Temperatur TO an der Oberfläche der Metallisierungsbahn 8, 9 und die Temperatur TK der piezokeramischen Schichten 3 angegeben. In das Diagramm ist die Curietemperatur für die piezoelektrischen Schichten 3 und die Löttemperatur für das verwendete Lötmaterial eingetragen.

In dem Diagramm sind die Kennlinien über die Zeit t aufgetragen.

Beim Beginn des Polarisierungs- und Lötvorganges sind die Leitungen 10, 11 an die Metallisierungsbahnen 8, 9 angedrückt, das Bauteil 2 ist noch nicht aufgeheizt und die Spannungsquelle 12 hat noch keine Polarisierungsspannung angelegt.

Zu einem ersten Zeitpunkt t1 wird die Polarisierungsspannung U angelegt. Gleichzeitig werden über die Heizblöcke 15 die Bauteile 2 aufgeheizt. Zu einem zweiten Zeitpunkt t2 erreicht die Temperatur TK der piezokeramischen Schicht 3 die Curietemperatur. Mit ansteigender Temperatur steigt die Leitfähigkeit der piezokeramischen Schichten 3, so dass der Strom I ansteigt und die Spannung U sinkt. Zu einem dritten Zeitpunkt t3 erreicht die Oberflächentemperatur TO der Bauteile 2 die Löttemperatur, so dass der Lötvorgang beginnt. Die Löttemperatur ist höher als die Curietemperatur. Zu einem vierten Zeitpunkt t4 ist der Lötprozess beendet und die Heizblöcke 15 werden abgeschaltet, so dass das Bauteil 2 abkühlt. In dem Zeitraum zwischen dem dritten Zeitpunkt t3 und dem vierten Zeitpunkt t4 wird der maximal fließende Strom begrenzt. Nach dem vierten Zeitpunkt t4 sinkt sowohl die Oberflächentemperatur TO als auch die Temperatur TK der piezokeramischen Schicht 3 ab. Durch die Abnahme der Temperatur steigt der Widerstand der piezokeramischen Schichten 3, so dass die Spannung U wieder ansteigt. Die Spannungsquelle 12 sorgt dafür, dass die Polarisationsspannung U einen Maximalwert nicht überschreitet. Dazu ist eine entsprechende Spannungsregelung in der Spannungsquelle 12 vorgesehen.

Unterhalb der Curietemperatur entsteht zu einem fünften Zeitpunkt t5 ein Ladungsimpuls, der sich in einem kurzzeitigen Ansteigen der Stromstärke I wiederspiegelt. Der Ladungsimpuls kann zur Bewertung des piezoelektrischen Aktors 1 verwendet werden. Vorzugsweise wird der Ladungsimpuls mit einem Ver gleichsladungsimpuls verglichen. Überschreitet oder unterschreitet der gemessene Ladungsimpuls den Vergleichsladungsimpuls um einen festgelegten Wert, so wird ein Defekt des piezoelektrischen Aktors erkannt. In einer weiteren bevorzugten Ausführungsform sind Vergleichskurven für die Polarisationsspannung während des Polarisations- und Lötvorganges in einem Steuergerät 17 abgelegt. Das Steuergerät 17 vergleicht die während des Löt- und Polarisationsvorganges anliegende Spannungskurve und/oder die anliegende Stromkurve mit der abgelegten Spannungskurve bzw. der abgelegten Stromkurve. Aus dem Vergleich kann eine Aussage über die Qualität der Polarisation und/oder über die Qualität des piezoelektrischen Aktors 1 getroffen werden. Weichen die gemessene Spannungskurve oder die gemessene Stromkurve um mehr als einen festgelegten Wert von der abgelegten Spannung- bzw. Stromkurve ab, so wird ein defekter Aktor 1 erkannt. Wird der Aktor 1 als defekt erkannt, so wird der Aktor 1 aussortiert und nicht weiter verarbeitet.

## Patentansprüche

1. Verfahren zum Herstellen einer elektrischen Kontaktierung eines piezoelektrischen Aktors (1) und zum Polarisieren des piezoelektrischen Aktors (1), wobei der Aktor (1) wenigstens eine piezokeramische Schicht (3) aufweist, die zwei beabstandete elektrische Kontakte (4, 8, 9) aufweist, wobei an die elektrischen Kontakte (4, 8, 9) elektrische Leitungen (5, 10, 11) angelötet werden, wobei während des Lötvorgangs der piezoelektrische Aktor (1) auf eine Löttemperatur erwärmt wird, **dadurch gekennzeichnet, dass** während des Lötvorganges an die Leitungen (5, 10, 11) eine Polarisierungsspannung angelegt wird und die piezokeramische Schicht (3) polarisiert wird.

2. Verfahren nach Anspruch 1, **dadurch gekennzeichnet, dass** ein Lotmaterial (13) verwendet wird, dessen Löttemperatur über der Curietemperatur der piezokeramischen Schicht (3) liegt.

3. Verfahren nach Anspruch 1 oder 2, **dadurch gekennzeichnet, dass** die Polarisierungsspannung auch während eines Abkühlprozesses angelegt wird, und dass die Spannung während der Abkühlung des Aktors auf einen maximalen Wert begrenzt wird.

4. Verfahren nach einem der Ansprüche 1 bis 3, **dadurch gekennzeichnet, dass** die Polarisierungsspannung während eines Aufheizvorgangs vor Erreichen einer maximalen Temperatur angelegt wird, und dass der Strom während des Erwärmens des Aktor (1) auf einen maximalen Wert begrenzt wird.

5. Verfahren nach einem der Ansprüche 1 bis 4, **dadurch gekennzeichnet, dass** die Spannung während der Polarisierung erfasst und ausgewertet wird, um die Polarisation und/oder den Aktor (1) zu bewerten.

6. Verfahren nach einem der Ansprüche 1 bis 5, **dadurch gekennzeichnet, dass** der während der Polarisierung fließende Strom erfasst und ausgewertet wird, um die Polarisation und/oder den Aktor zu bewerten.

7. Verfahren nach einem der Ansprüche 1 bis 6, **dadurch gekennzeichnet, dass** die Leitungen (10, 11) über Heizblöcke (15) auf Lötflächen der Kontakte (8, 9) gedrückt werden, und dass die Heizblöcke (15) den Aktor (1) wenigstens teilweise erwärmen.

8. Verfahren nach einem der Ansprüche 1 bis 7, **dadurch gekennzeichnet, dass** mehrere Aktoren (1) gleichzeitig mit Leitungen (10, 11) verlötet und polarisiert werden.

9. Verfahren nach Anspruch 8, **dadurch gekennzeichnet, dass** die Leitungen (10, 11) eines Kontaktes (8, 9) einstückig für mehrere Aktoren (1) beim Verlöten und Polarisieren verwendet werden, und dass nach dem Verlöten und dem Polarisieren die Leitungen (10, 11) für jeden Aktor (1) in einzelne Leitungsstücke aufgetrennt wird.

10. Verfahren nach Anspruch 9, **dadurch gekennzeichnet, dass** die Leitungen (10, 11) vor dem Verlöten und Polarisieren an Kontaktstifte (6, 7) angeschlossen sind.

11. Verfahren nach einem der Ansprüche 1 bis 10, **dadurch gekennzeichnet, dass** der Aktor (1) während des Lötvorganges über die Curietemperatur der piezokeramischen Schicht (3) erwärmt wird.

## Claims

1. Method for producing electrical contacting of a piezoelectric actuator (1) and for polarising the piezoelectric actuator (1), said actuator (1) having at least one piezoceramic layer (3) which has two spaced electric contacts (4, 8, 9), electric conductors (5, 10, 11) being soldered to the electric contacts (4, 8, 9), the piezoelectric actuator (1) being heated up to a soldering temperature during the soldering process, **characterised in that** during the soldering process a polarising voltage is applied to the conductors (5, 10, 11) and the piezoceramic layer (3) is polarised.

2. Method according to claim 1, **characterised in that** a solder material (13) is used whose soldering temperature is above the Curie temperature of the piezoceramic layer (3).

3. Method according to claim 1 or 2, **characterised in that** the polarising voltage is also applied during a cooling process, and that the voltage is limited to a maximum value during cooling of the actuator.

4. Method according to one of the claims 1 to 3, **characterised in that** the polarising voltage is applied during a heating process before a maximum temperature is reached, and that the current is limited to a maximum value during heating of the actuator (1).

5. Method according to one of the claims 1 to 4, **characterised in that** the voltage present during polarisation is recorded and evaluated in order to assess the polarisation and/or the actuator (1).

6. Method according to one of the claims 1 to 5, **characterised in that** the current flowing during polarisation is recorded and evaluated in order to assess the polarisation and/or the actuator (1).

7. Method according to one of the claims 1 to 6, **characterised in that** the conductors (10, 11) are pressed onto soldering surfaces of the contacts (8, 9) via heating blocks (15) and that the heating blocks (15) at least partially heat up the actuator (1).

8. Method according to one of the claims 1 to 7, **characterised in that** a plurality of actuators (1) are soldered to conductors (10, 11) and polarised simultaneously.

9. Method according to claim 8, **characterised in that** the conductors (10, 11) of a contact (8, 9) are used monolithically for a plurality of actuators (1) during soldering and polarisation, and that after soldering and polarisation the conductors (10, 11) are divided into individual conductor pieces for each actuator (1).

10. Method according to claim 9, **characterised in that** the conductors (10, 11) are connected to contact pins (6, 7) prior to soldering and polarisation.

11. Method according to one of the claims 1 to 10, **characterised in that** the actuator (1) is heated up to above the Curie temperature of the piezoceramic layer (3) during the soldering process.

## Revendications

1. Procédé destiné à fabriquer un contact électrique d'un actionneur piézoélectrique (1) et à polariser l'actionneur piézoélectrique (1), l'actionneur (1) présentant au moins une couche piézocéramique (3) qui comporte deux contacts électriques espacés (4, 8, 9), dans lequel des lignes électriques (5, 10, 11) sont brasées sur les contacts électriques (4, 8, 9), et l'actionneur piézoélectrique (1) est chauffé à une température de brasage pendant le processus de brasage,
**caractérisé en ce que**,
pendant le processus de brasage, une tension de polarisation est appliquée aux lignes (5, 10, 11) et la couche piézocéramique (3) est polarisée.

2. Procédé selon la revendication 1,
**caractérisé en ce qu'**
on utilise un matériau de brasage (13) dont la température de brasage est supérieure à la température de Curie de la couche piézocéramique (3).

3. Procédé selon la revendication 1 ou 2,
**caractérisé en ce que**
la tension de polarisation est également appliquée pendant un processus de refroidissement et la tension est limitée sur une valeur maximale pendant le refroidissement de l'actionneur.

4. Procédé selon l'une des revendications 1 à 3,
**caractérisé en ce que**
la tension de polarisation est appliquée pendant un processus de chauffage avant d'atteindre une température maximale, et le courant est limité sur une valeur maximale pendant le chauffage de l'actionneur (1).

5. Procédé selon l'une des revendications 1 à 4,
**caractérisé en ce que**
la tension est détectée et évaluée pendant la polarisation pour juger la polarisation et/ou l'actionneur (1) .

6. Procédé selon l'une des revendications 1 à 5,
**caractérisé en ce que**
le courant circulant pendant la polarisation est détecté et évalué pour juger la polarisation et/ou l'actionneur.

7. Procédé selon une des revendications 1 à 6,
**caractérisé en ce que**
les lignes (10, 11) sont poussées par des blocs de chauffage (15) sur des surfaces de brasage des contacts (8, 9) et les blocs de chauffage (15) chauffent au moins partiellement l'actionneur (1).

8. Procédé selon l'une des revendications 1 à 7,
**caractérisé en ce que**
plusieurs actionneurs (1) sont brasés et polarisés simultanément avec des lignes (10, 11).

9. Procédé selon la revendication 8,
**caractérisé en ce que**
les lignes (10, 11) d'un contact (8, 9) sont utilisées d'un seul tenant pour plusieurs actionneurs (1) pendant le brasage et la polarisation, et, après le brasage et la polarisation, les lignes (10, 11) pour chaque actionneur (1) sont séparées en tronçons de lignes individuels.

10. Procédé selon la revendication 9,
**caractérisé en ce que**
les lignes (10, 11) sont raccordées à des fiches de contact (6, 7) avant le brasage et la polarisation.

11. Procédé selon l'une des revendications 1 à 10,
**caractérisé en ce que**
l'actionneur (1) est chauffé pendant le processus de brasage au-dessus de la température de Curie de la couche piézocéramique (3).
